# FASCICULE DE BREVET EUROPEEN

(11) **EP 3 370 132 B1**
(45) Date de publication et mention de la délivrance du brevet: **01.06.2022**
(21) Numéro de dépôt: 18158445.9
(22) Date de dépôt: 23.02.2018
(51) Int. Cl.: G06F 1/16, G06F 1/18, G07G 1/00, F16M 11/08, H02G 3/08, H02G 3/10

(54) **DISPOSITIF DE SUPPORT POUR TERMINAL DE PAIEMENT**
HALTERUNGSVORRICHTUNG FÜR ZAHLUNGSENDGERÄT
SUPPORT DEVICE FOR PAYMENT TERMINAL

(30) Priorité: 02.03.2017 FR 1751720
(43) Date de publication de la demande: 05.09.2018
(73) Titulaire: Banks and Acquirers International Holding, 75015 Paris (FR)
(72) Inventeur: ROUX, Julien, 69300 CALUIRE (FR); ROBERT, Franck, 92150 Suresnes (FR); DEDIEU, Philippe, 07500 GUILHERAND-GRANGES (FR)
(74) Mandataire: Vidon Brevets & Stratégie

(56) Documents cités:
- WO-A1-97/06716
- WO-A1-2016/039778
- US-A- 5 802 459
- US-A1- 2005 213 295
- US-A1- 2006 133 016
- US-A1- 2008 042 020
- US-A1- 2009 057 502
- US-B1- 7 546 019

## Description

### 1. Domaine de l'invention

L'invention concerne le domaine des supports utilisés pour fixer un appareil sur un socle de façon mobile, et notamment les supports pour terminal de paiement.

### 2. Art Antérieur

Afin de réaliser une transaction de paiement électronique entre un acheteur et un commerçant, il est possible d'utiliser un terminal de paiement électronique installé dans la boutique du commerçant par exemple.

Un tel terminal de paiement est par exemple un appareil électronique capable de lire les données d'une carte bancaire insérée dans l'appareil ou positionnée à proximité de l'appareil dans le cas d'un paiement dit sans contact. Un tel terminal de paiement est connecté à un réseau de communication afin de transmettre les données électroniques relatives à la transaction à un serveur d'authentification.

Il existe des terminaux de paiement adaptés pour être montés sur un support comprenant une base fixe, par exemple posée sur le comptoir d'un commerçant, et un plateau monté mobile sur la base de sorte que le terminal de paiement puisse être tourné face au commerçant ou face à l'acheteur selon la personne qui doit interagir avec le terminal de paiement lors d'une transaction de paiement.

Le terminal de paiement doit en général être relié à une alimentation en courant électrique, à un réseau de communication, et à d'autres équipements tels qu'une caisse enregistreuse, un ordinateur, etc...

Ainsi, de nombreux câbles de connexion peuvent être branchés sur le terminal de paiement et plus particulièrement sur la base sur laquelle le terminal de paiement est fixé.

Les différents équipements et prises d'alimentation, ou réseau peuvent être agencés de différentes manières selon la configuration du local du commerçant, de sorte qu'il n'est pas aisé de prévoir la direction depuis laquelle les câbles de connexion arriveront vers la base du support du terminal de paiement.

De plus, la présence de nombreux câbles de connexion branchés sur la base du support du terminal de paiement peut être disgracieuse.

Le document US 2006/133016 A1 décrit un système de fixation d'un écran sur une surface de sorte que la fixation de l'écran sur la surface ne nécessite pas d'accéder à l'arrière de la surface ou au-dessous de la surface. En particulier, US 2006/133016 A1 décrit un système de fixation comprenant une base (286) permettant de sécuriser l'écran sur une surface (272), comme par exemple une table, et un capot amovible (234) fixé au support de l'écran pour couvrir le côté ouvert de la base (286). Le capot amovible peut comporter un trou pour le passage des câbles de l'écran.

### 3. Exposé de l'invention

L'invention vient améliorer l'état de la technique. Elle concerne un dispositif de support pour terminal de paiement selon la revendication 1.

Le dispositif de support permet ainsi de cacher les câbles de connexion reliés à la base tout en offrant plusieurs directions de sortie pour ces câbles. En effet, 4 directions de sortie sont possibles: vers la gauche du dispositif de support, vers la droite du dispositif de support, vers l'arrière du dispositif de support ou vers le sol. Ainsi, les sorties de câbles du dispositif de support sont faciles à agencer quelle que soit la configuration du local du commerçant tout en cachant la connexion des câbles à la base.

Les moyens de guidage permettent une mise en place plus facile du capot lorsque des câbles sont branchés sur la face arrière de la base et doivent sortir vers la gauche ou la droite du dispositif de support. En effet, les moyens de guidage permettent de maintenir les câbles au niveau des ouvertures latérales même lorsque le capot n'est pas monté. Ainsi, lors du montage du capot, il n'est pas nécessaire qu'un utilisateur maintienne les câbles ou ré-agence le positionnement des câbles pour monter le capot.

Selon un mode particulier de réalisation de l'invention, les ouvertures du capot sont formées sur le bord inférieur des faces du capot. Ces ouvertures ont une longueur de 40 mm et une hauteur de 8mm.

Selon un mode particulier de réalisation de l'invention, le capot comprend une patte de fixation à l'avant de la face latérale gauche et une patte de fixation à l'avant de la face latérale droite, lesdites pattes de fixation étant destinées à être insérées dans des logements prévus sur la base de chaque côté de la face arrière de la base. Ainsi, une fois monté sur la base par translation, le capot est maintenu fixe à l'avant par rapport à la base.

Selon un mode particulier de réalisation de l'invention, le capot comprend également deux crochets à l'intérieur de la face arrière du capot et placés et part et d'autre de l'ouverture de la face arrière du capot, lesdits crochets étant destinés à être insérés dans des logements prévus sur un bord arrière du socle de la base. Ainsi, l'arrière du capot est maintenu fixe sur le socle du dispositif de support.

Selon un mode particulier de réalisation de l'invention, les moyens de guidage comprennent un nombre impair de nervures sensiblement alignées, lesdites nervures étant espacées de sorte qu'un câble de connexion puisse passer entre deux nervures. Selon un mode particulier de réalisation de l'invention, les nervures sont espacées de 6,2mm. Un tel espacement est suffisamment large pour le passage de la plupart des câbles de connexion tout en étant suffisamment étroit pour maintenir le câble dans la direction de sortie prévue.

Selon un mode particulier de réalisation de l'invention, les nervures comprennent un ergot formé au centre et sur le dessus de la nervure de sorte qu'un câble passant entre deux nervures est bloqué vers le bas par l'ergot. Ainsi, les câbles passant entre les nervures sont maintenus selon l'axe vertical et ne risque pas de se déloger verticalement du guide.

### 4. Liste des figures

D'autres caractéristiques et avantages de l'invention apparaîtront plus clairement à la lecture de la description suivante d'un mode de réalisation particulier, donné à titre de simple exemple illustratif et non limitatif, et des dessins annexés, parmi lesquels :
- la figure 1 présente une vue schématique de dessus du dispositif de support pour terminal de paiement selon un mode particulier de réalisation de l'invention;
- la figure 2 présente une vue schématique arrière du dispositif de support pour terminal de paiement selon un mode particulier de réalisation de l'invention;
- la figure 3 présente une vue schématique arrière du dispositif de support pour terminal de paiement selon un mode particulier de réalisation de l'invention, dans laquelle le capot a été retiré de la base du dispositif de support;
- la figure 4 présente une vue schématique de la face arrière de la base du dispositif de support pour terminal de paiement selon un mode particulier de réalisation de l'invention;
- la figure 5 illustre une vue en perspective du capot configuré pour être installé sur la face arrière de la base du dispositif de support pour terminal de paiement selon un mode particulier de réalisation de l'invention;
- la figure 6 illustre une vue schématique du socle du dispositif de support pour terminal de paiement selon un mode particulier de réalisation de l'invention;
- la figure 7 illustre une vue schématique de dessus du socle du dispositif de support pour terminal de paiement selon un mode particulier de réalisation de l'invention;
- la figure 8 illustre une vue schématique de côté du socle du dispositif de support pour terminal de paiement selon un mode particulier de réalisation de l'invention.

### 5. Description d'un mode de réalisation de l'invention

### 5.1 Principe général

L'invention concerne un dispositif de support pour terminal de paiement comprenant une base configurée pour recevoir une pluralité de câbles de connexion et un capot, aussi appelé cache-câbles, configuré pour être installé sur la base et cacher les câbles de connexion branchés sur la base.

Avantageusement, le dispositif de support comprend plusieurs sorties de câbles placées selon quatre directions à l'arrière du dispositif de support de sorte que la connexion de la base avec les câbles soit aisée quel que soit l'environnement dans lequel le dispositif de support est placé.

Avantageusement, le dispositif de support comprend également un socle sur lequel des passe-câbles sont ménagés pour guider un câble vers l'extérieur selon la direction de sortie choisie pour ce câble.

Ainsi, les câbles branchés sur la base sont agencés correctement, en limitant les chevauchements et emmêlements de câbles.

### 5. 2 Exemples de mise en œuvre

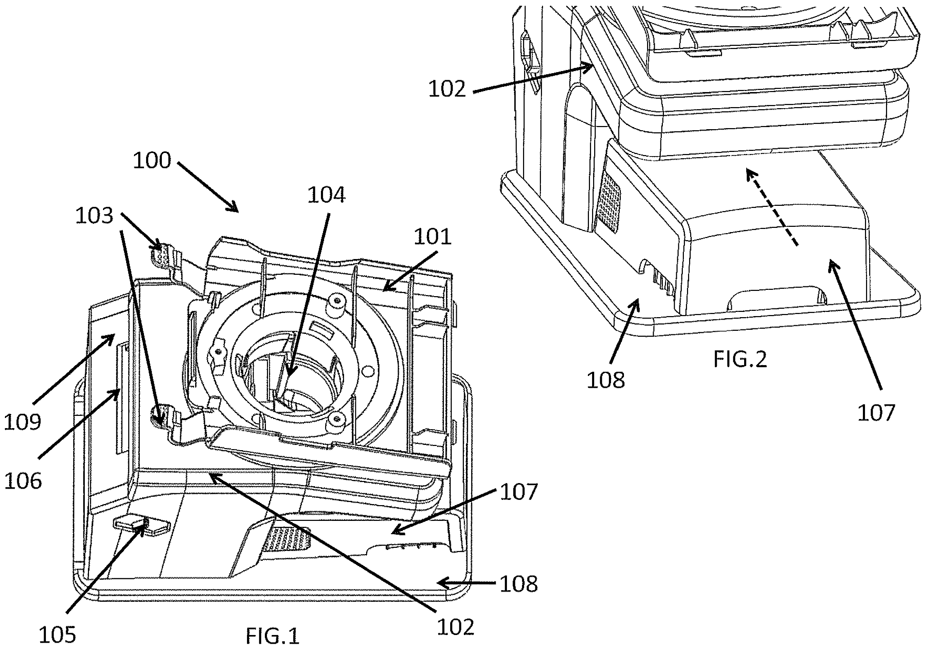

La figure 1 présente une vue schématique en oblique du dispositif (100) de support pour terminal de paiement selon un mode particulier de réalisation de l'invention.

Le support (100) comprend une base (102) et un plateau (101) monté sur la base de manière mobile en rotation. Le plateau (101) est apte à recevoir le terminal de paiement et comprend des moyens de fixation permettant de fixer le terminal de paiement sur le plateau. Par exemple, les moyens de fixation du terminal de paiement sur le plateau sont des clips (103) venant accrocher le haut du terminal de paiement lorsque le terminal de paiement est placé sur le plateau. D'autres moyens de fixation du terminal de paiement sur le plateau (101) sont bien entendu possibles.

Le support (100) comprend un trou traversant (104) formé dans le plateau et dans la base qui permet de faire passer des câbles de connexion permettant de relier la base (102) au terminal de paiement. La base (102) et le plateau (101) sont fixés par des clips (non représentés) placés sur la base à l'intérieur du trou traversant (104) et autorisant la rotation du plateau par rapport à la base.

La base comprend également des connectiques (non représentées sur la figure 1) permettant de relier la base à différents équipements ou prise de courant électrique ou prise réseau, nécessaires au fonctionnement du terminal de paiement. Ces connectiques sont placées sous le capot (107) de la base. Un câble ou des câbles peuvent être placés dans le trou traversant (104) afin de relier le terminal de paiement aux connectiques de la base (102) lorsqu'il est placé sur le plateau (101).

De manière classique, la base (102) comprend également un socle (108) pour poser le support sur une surface plane, une fente (106) par laquelle des tickets imprimés de transaction de paiement peuvent sortir depuis une trappe-papier (109), un bouton (105) d'ouverture de la trappe-papier (109).

La base (102) comprend également un capot (107) permettant de cacher les composants et les connectiques de la base (102).

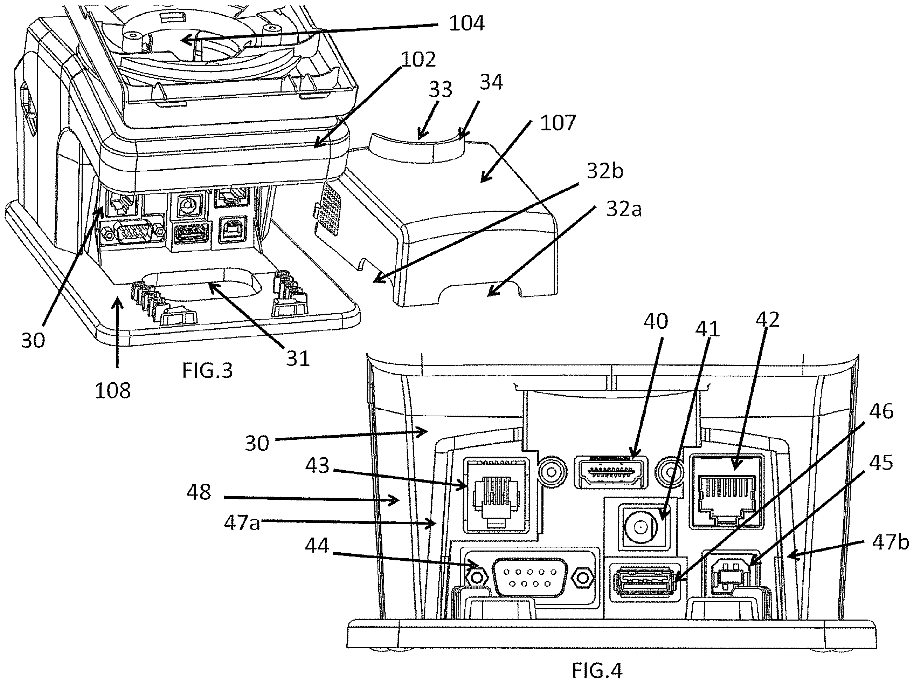

La figure 2 présente plus précisément une vue schématique arrière du dispositif de support pour terminal de paiement selon un mode particulier de réalisation de l'invention. La figure 2 illustre la face arrière de la base (102). Les connectiques de la face arrière de la base (102) illustrés en figure 4 sont cachés par le capot (107). Le capot (107) est monté sur la base (102) par translation de l'arrière vers l'avant (représentée par la flèche en pointillés sur la figure 2) en glissant sur le socle (108) du dispositif de support.

La figure 3 présente une vue schématique arrière du dispositif de support pour terminal de paiement selon un mode particulier de réalisation de l'invention, dans laquelle le capot (107) a été retiré de la base (102) du dispositif de support.

La face arrière (30) de la base (102) présente une pluralité de connectiques permettant de relier via des câbles différents équipements ou prise à la base (102).

La figure 4 illustre une vue schématique de la face arrière (30) et un exemple de connectiques présentes sur cette face (30). Selon un mode particulier de réalisation de l'invention, la face arrière (30) de la base (102) comprend une prise Modem RJ 11 (43), une port série RS-232 DB9 (44), un port Ethernet RJ 45 (42), un port USB B (45), un port USB A (46), une prise Power DC Jack (41). Ces différentes connectiques sont concentrées sur une sortie connecteur (40) destinée à être reliée au terminal de paiement via un câble passant par le trou traversant 104 illustré en figure 1, lorsque le terminal de paiement est placé sur le plateau (101).

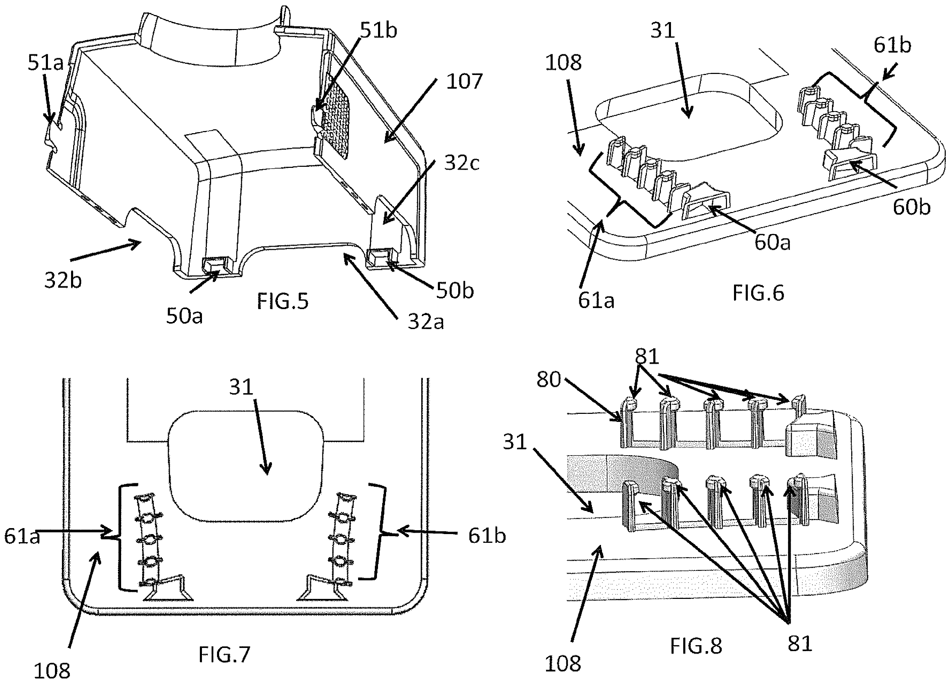

Le capot (107) est illustré en figure 3 et en figure 5. Le capot (107) comprend trois ouvertures (32a, 32b et 32c) configurées pour permettre le passage d'au moins un câble de connexion branché sur la face arrière (30) de la base. Les ouvertures (32a, 32b, 32c) sont formées respectivement sur la face arrière du capot (107), sur la face latérale gauche et sur la face latérale droite du capot.

Les ouvertures (32a, 32b et 32c) son formées sur le bord inférieur des faces arrière, latérale gauche et latéral droite du capot. Elles sont dimensionnées de sorte que les câbles puissent passer par l'ouverture tout en laissant le capot (107) en place lorsqu'il est monté par translation sur la base (102) et le socle (108). Par exemple, les ouvertures (32a, 32b et 32c) ont une longueur de 40 mm et une hauteur de 8 mm.

La face supérieure du capot (107) présente une ouverture (33) en arc de cercle sur l'avant surmontée d'une nervure (34) courant le long de l'ouverture (33). L'ouverture (33) et la nervure (34) permettant de prolonger les bords inférieurs du trou traversant (104) de la base (102) lorsque le capot (107) est monté sur la base (102) et le socle (108). Ainsi, la connectique (40) et le câble (non représenté) branché sur cette connectique et relié au terminal de paiement sont protégés au niveau de la jonction entre le capot (107) et la face arrière (30) de la base (102).

Tel qu'illustré en figure 5, le capot comprend une patte de fixation (51a) à l'avant de la face latérale gauche et une patte de fixation (51b) à l'avant de la face latérale droite. De telles pattes de fixation (51a, 51b) sont destinées à être insérées dans des logements (47a, 47b illustrés en figure 4) prévus sur la base (102) de chaque côté de la face arrière (30). Ces logements correspondent par exemple à un jeu prévu entre la face (30) et l'habillage (48) de la base (102).

Le capot (107) comprend également deux crochets (50a, 50b) à l'intérieur de la face arrière du capot et placés de part et d'autre de l'ouverture (32a) de la face arrière du capot. De tels crochets (50a, 50b) sont destinés à être insérés dans des logements (60a et 60b illustrés en figure 6) prévus sur le bord arrière du socle (108) de la base (102).

Comme illustré en figure 3, la base (102) est montée fixe sur un socle (108). La face arrière (30) de la base (102) est sensiblement perpendiculaire au socle (108). Avantageusement, le socle (108) comprend une ouverture (31) configurée pour permettre le passage d'au moins un câble de connexion branché sur ladite face arrière vers le sol. Le socle (108) étant fixe par rapport à la base (102), l'ouverture (31) est dimensionnée de sorte qu'une installation des câbles de connexion devant passer par l'ouverture (31) soit aisée. Par exemple, l'ouverture (31) est de forme sensiblement trapézoïdale avec une hauteur de 38mm et une base de longueur 52,5mm.

Comme illustré en figures 3 et 6-8, le socle (108) comprend sur sa partie arrière et de chaque côté de l'ouverture (31) formée dans le socle (108), des moyens de guidage (61a, 61b) permettant de guider des câbles de connexion branchés sur la face arrière (30) de la base (102) vers l'ouverture (32b, 32c) d'une des faces latérales du capot (107).

Ces moyens de guidage sont mis en oeuvre sous la forme de nervures (80), sensiblement alignées le long d'un arc de cercle de très faible courbure dans une direction orthogonale à la face arrière (30) de la base (102). Sur la figure 7, les nervures sont placées le long d'un arc de cercle de faible courbure, pour permettre une installation des câbles plus aisée lorsqu'on s'éloigne de la base. Une telle représentation des nervures n'est qu'un exemple illustratif et un alignement des nervures le long d'un axe perpendiculaire à la face arrière est également possible.

De chaque côté de l'ouverture (31), les moyens de guidage comprennent un nombre impair de nervures. Par exemple, 5 nervures sont formées de chaque côté de l'ouverture (31) permettant de faire sortir jusqu'à 4 câbles de connexion par la droite et 4 câbles de connexion par la gauche.

Il est aussi possible d'envisager des moyens de guidage sous la forme de nervures, placés perpendiculairement aux moyens de guidage (61a, 61b) et formés entre le bord de l'ouverture (31) et le bord arrière du socle (108) de sorte que les câbles de connexion devant sortir par l'arrière soient également guidés.

Les nervures sont formées de sorte que l'espacement entre deux nervures permette que tout type de câbles de connexion puisse passer entre deux nervures. Par exemple, les nervures sont espacées de 6,2mm.

Un tel espacement est suffisamment large pour le passage de la plupart des câbles de connexion tout en étant suffisamment étroit pour maintenir le câble dans la direction de sortie prévue.

Comme illustré en figure 8, les nervures (80) comprennent chacune un ergot (81) formé au centre de la nervure et sur le dessus de la nervure de sorte qu'un câble passant entre deux nervures est bloqué vers le bas par l'ergot (81). A la hauteur des ergots, l'espacement entre deux nervures est réduit par rapport à l'espacement au bas des nervures. L'espacement entre les nervures à la hauteur des ergots est par exemple de 4,2mm.

L'insertion d'un câble entre deux nervures est alors fait en jouant avec la souplesse de l'habillage du câble, en forçant légèrement pour passer le rétrécissement de l'espace entre les nervures au niveau des ergots.

Les câbles passant entre les nervures sont maintenus selon l'axe vertical et ne risque pas de se déloger verticalement du guide.

Le capot (107) est monté sur le dispositif de support par translation. La face avant du capot (107) comprenant l'ouverture (33) est placée en face de la face arrière (30) de la base (102) en contact avec le socle (108). L'arrière du capot (107) est en légère surélévation si des câbles branchés sur la face arrière (30) de la base (102) sont maintenus vers les sorties droite et gauche du dispositif. Le capot (107) est alors glissé vers la base (102), les pattes de fixation (51a, 51b) sont insérées dans les logements prévus autour de la face arrière (30) de la base (102). Au cours de la translation du capot (107) vers la base (102), lorsque les ouvertures (32b et 32c) formées sur les faces latérales du capot (107) sont placées en regard des câbles maintenus sur le socle (108) en direction des sorties gauche et droite du dispositif, l'arrière du capot (107) peut s'abaisser et venir au contact du socle (108). La translation du capot (107) poursuivie le long du socle (108) jusqu'à ce que les crochets (50a, 50b) s'insèrent dans les logements prévus (60a, 60b) et bloquent la translation du capot (107). Le capot (107) est alors en place sur le dispositif (100) tel qu'illustré en figures 1 et 2.

## Revendications

1. Dispositif de support (100) pour terminal de paiement, comprenant un socle (108), une base (102) montée fixe sur ledit socle et adaptée pour recevoir sur une face arrière (30) une pluralité de câbles de connexion, et un capot (107) adapté pour être monté en translation sur la base (102) et permettant de cacher lesdits câbles de connexion lorsque la pluralité de câbles de connexion est branchée sur ladite face arrière (30) de la base (102), les parties avant du capot et du socle étant les plus proches de la base, les parties arrières du capot et du socle étant les plus éloignées de la base, le dispositif (100) est **caractérisé en ce que** :
- le capot (107) comprend trois ouvertures (32a, 32b, 32c) configurées pour permettre le passage de câbles de connexion branchés sur ladite face arrière (30) de la base, les trois ouvertures (32a, 32b, 32c) étant formées sur le bord inférieur respectivement d'une face latérale gauche, d'une face latérale droite et d'une face arrière du capot (107),
- le socle (108) est sensiblement perpendiculaire à ladite face arrière (30) de ladite base (102), une partie arrière dudit socle (108) comprenant :
- une ouverture (31) configurée pour permettre le passage de câbles de connexion branchés sur ladite face arrière (30) de ladite base (102) ;
- des moyens de guidages (61a, 61b) disposés sur ledit socle, de part et d'autre de ladite ouverture dudit socle, en regard des ouvertures de la face latérale gauche et de la face latérale droite dudit capot, lorsque le capot est monté sur ladite base, les moyens de guidage étant configurés pour guider les câbles de connexion vers l'ouverture de la face latérale droite du capot ou vers l'ouverture de la face latérale gauche du capot.

2. Dispositif de support selon la revendication 1, dans lequel lesdites ouvertures du capot ont une longueur de 40 mm et une hauteur de 8mm.

3. Dispositif de support selon la revendication 1, dans lequel le capot comprend une patte de fixation à l'avant de la face latérale gauche et une patte de fixation à l'avant de la face latérale droite, lesdites pattes de fixation étant destinées à être insérées dans des logements prévus sur la base de chaque côté de la face arrière de la base.

4. Dispositif de support selon la revendication 3, dans lequel le capot comprend également deux crochets à l'intérieur de la face arrière du capot et placés de part et d'autre de l'ouverture de la face arrière du capot, lesdits crochets étant destinés à être insérés dans des logements prévus sur un bord arrière du socle de la base.

5. Dispositif de support selon la revendication 1, dans lequel les moyens de guidage comprennent un nombre impair de nervures sensiblement alignées, lesdites nervures étant espacées de sorte qu'un câble de connexion puisse passer entre deux nervures.

6. Dispositif de support selon la revendication 5, dans lequel lesdites nervures sont espacées de 6,2mm.

7. Dispositif de support selon la revendication 6, dans lequel chaque nervure comprend un ergot formé au centre et sur le dessus de la nervure de sorte qu'un câble passant entre deux nervures est bloqué vers le bas par l'ergot.

## Patentansprüche

1. Haltevorrichtung (100) für Zahlungsendgerät, umfassend einen Sockel (108), eine Basis (102), die fest auf dem Sockel montiert ist und geeignet ist, auf einer Rückseite (30) mehrere Verbindungskabel aufzunehmen, und eine Haube (107), die geeignet ist, um in Translation auf der Basis (102) befestigt zu werden und die ermöglicht, die Verbindungskabel zu verstecken, wenn die mehreren Verbindungskabel auf der Rückseite (30) der Basis (102) angeschlossen sind, wobei die vorderen Teile der Haube und des Sockels der Basis am nächsten sind, wobei die hinteren Teile der Haube und des Sockels am weitesten von der Basis entfernt sind, die Vorrichtung (100) ist **dadurch gekennzeichnet, dass**:
- die Haube (107) drei Öffnungen (32a, 32b, 32c) aufweist, die konfiguriert sind, um den Durchgang von Verbindungskabeln zu ermöglichen, die auf der Rückseite (30) der Basis angeschlossen sind, wobei die drei Öffnungen (32a, 32b, 32c) am unteren Rand jeweils einer linken Seitenfläche, einer rechten Seitenfläche und einer hinteren Fläche der Haube (107) ausgebildet sind,
- der Sockel (108) im Wesentlichen senkrecht zur Rückseite (30) der Basis (102) ist, wobei ein hinterer Teil des Sockels (108) aufweist:
- eine Öffnung (31), die konfiguriert sind, um den Durchgang von Verbindungskabeln zu ermöglichen, die auf der Rückseite (30) der Basis (102) angeschlossen sind,
- Führungsmittel (61a, 61b), die auf dem Sockel auf beiden Seiten der Öffnung der Basis des Sockels gegenüber den Öffnungen der rechten Seitenfläche und der linken Seitenfläche der Haube angeordnet sind, wenn die Haube auf der Basis befestigt ist, wobei die Führungsmittel konfiguriert sind, um die Verbindungskabel zur Öffnung der rechten Seitenfläche der Haube oder zur linken Seitenfläche der Haube zu führen.

2. Haltevorrichtung nach Anspruch 1, wobei die Öffnungen der Haube eine Länge von 40 mm und eine Höhe von 8 mm aufweisen.

3. Haltevorrichtung nach Anspruch 1, wobei die Haube eine Befestigungslasche vor der linken Seitenfläche und eine Befestigungslasche vor der rechten Seitenfläche aufweist, wobei die Befestigungslaschen dazu bestimmt sind, in Aufnahmen eingefügt zu werden, die auf der Basis auf jeder Seite der Rückseite der Basis vorgesehen sind.

4. Haltevorrichtung nach Anspruch 3, wobei die Haube ebenfalls zwei Haken im Inneren der Rückseite der Haube aufweist, die auf beiden Seiten der Öffnung der Rückseite der Haube angeordnet sind, wobei die Haken dazu bestimmt sind, in Aufnahmen eingefügt zu werden, die an einer Hinterkante des Sockels der Basis vorgesehen sind.

5. Haltevorrichtung nach Anspruch 1, wobei die Führungsmittel eine ungerade Anzahl von im Wesentlichen fluchtend angeordneten Rippen aufweisen, wobei die Rippen derart beabstandet sind, dass ein Verbindungskabel zwischen zwei Rippen verlaufen kann.

6. Haltevorrichtung nach Anspruch 5, wobei die Rippen 6,2 mm voneinander beabstandet sind.

7. Haltevorrichtung nach Anspruch 6, wobei jede Rippe einen Sporn aufweist, der in der Mitte und auf der Oberseite der Rippe derart gebildet ist, dass ein Kabel, das zwischen zwei Rippen verläuft, von dem Sporn nach unten blockiert wird.

## Claims

1. Support device (100) for a payment terminal, comprising a footing (108), a base (102) fixedly mounted on said footing and adapted to receive a plurality of connection cables on a rear face (30), and a cover (107) adapted to be mounted in translation on the base (102) and enabling the concealment of said connection cables when the plurality of connection cables is connected to said rear face (30) of the base (102), the front parts of the cover and the footing being closest to the base, the rear parts of the cover and the footing being furthest from the base, the device (100) being **characterized in that**:
- the cover (107) has three apertures (32a, 32b, 32c) configured to enable the passage of connection cables connected to said rear face (30) of the base, the three apertures (32a, 32b, 32c) being formed on the lower edge respectively of a left lateral face, of a right lateral face and of a rear face of the cover (107),
- the footing (108) is substantially perpendicular to said rear face (30) of said base (102), a rear part of said footing (108) comprising:
- an aperture (31) configured to enable the passage of connection cables connected to said rear face (30) of said base (102);
- guiding means (61a, 61b) arranged on said footing, on either side of said aperture of said footing, facing the apertures of the left lateral face and of the right lateral face of said cover, when the cover is mounted on said base, the guiding means being configured to guide the connection cables towards the aperture of the right lateral face of the cover or towards the aperture of the left lateral face of the cover.

2. Support device according to claim 1, wherein said apertures of the cover have a length of 40 mm and a height of 8 mm.

3. Support device according to claim 1, wherein the cover comprises an affixation lug in front of the left lateral face and an affixation lug on the front of the right lateral face, said affixation lugs being intended for insertion in housings provided on the base, on either side of the rear face of the base.

4. Support device according to claim 3, wherein the cover also comprises two hooks within the rear face of the cover and placed on either side of the aperture of the rear face of the cover, said hooks being intended for insertion in housings provided on the rear edge of the footing of the base.

5. Support device according to claim 1, wherein the guiding means comprise an odd number of substantially aligned ribs, said ribs being spaced so that a connection cable can pass between two ribs.

6. Support device according to claim 5, wherein said ribs are spaced by 6.2 mm.

7. Support device according to claim 6, wherein each rib comprises a spike formed at the center and on top of the rib so that a cable passing between two ribs is blocked towards the bottom by the spike.
